# EUROPEAN PATENT SPECIFICATION

(11) **EP 2 003 567 B1**
(45) Date of publication and mention of the grant of the patent: **15.02.2012**
(21) Application number: 06730837.9
(22) Date of filing: 31.03.2006
(51) Int. Cl.: G06F 12/06, G11C 11/401

(54) **MEMORY APPARATUS, ITS CONTROL METHOD, ITS CONTROL PROGRAM, MEMORY CARD, CIRCUIT BOARD, AND ELECTRONIC DEVICE**
SPEICHERVORRICHTUNG, STEUERVERFAHREN DAFÜR, STEUERPROGRAMM DAFÜR, SPEICHERKARTE, LEITERPLATTE UND ELEKTRONISCHE EINRICHTUNG
APPAREIL DE MÉMOIRE, PROCÉDÉ ET PROGRAMME DE COMMANDE, CARTE MÉMOIRE, CARTE DE CIRCUITS IMPRIMÉS ET DISPOSITIF ÉLECTRONIQUE

(43) Date of publication of application: 17.12.2008
(73) Proprietor: Fujitsu Ltd., Kawasaki-shi, Kanagawa 211-8588 (JP)
(72) Inventor: MIYAMOTO, Toshihiro, Kawasaki-shi, Kanagawa 211-8588 (JP); TAKIGAMI, Akio, Kawasaki-shi, Kanagawa 211-8588 (JP); INOKO, Masaya, Kawasaki-shi, Kanagawa 211-8588 (JP); SUZUKI, Takayoshi, Kawasaki-shi, Kanagawa 211-8588 (JP); ONO, Hiroyuki, Kawasaki-shi, Kanagawa 211-8588 (JP)
(74) Representative: Kreutzer, Ulrich
(86) International application number: PCT/JP2006/306889
(87) International publication number: WO 2007/116483

(56) References cited:
- JP-A- 04 248 641
- JP-A- 04 325 993
- JP-A- 11 073 368
- JP-A- 2000 194 598
- JP-A- 2005 322 251
- US-A- 5 812 491
- US-B1- 6 594 167
- US-B1- 6 691 204
- NAONO N. ET AL.: 'Kosoku Digital System Sekkeiho Shousetsu', 15 October 2001, NIKKEI BUSINESS PUBLICATIONS, INC. pages 311 - 324, XP003018507

## Description

### [Technical Field]

The present invention relates to a memory that is used for data storage in an electronic apparatus such as a personal computer (PC), and, more particularly, to a memory device having an interface function, a control method for the same, a control program for the same, a memory card, a circuit board and electronic equipment.

### [Background Art]

A PC is provided with such JEDEC (Joint Electron Device Engineering Council) standard memories as a SDRAM (Synchronous Dynamic Random Access Memory) and DDR-SDRAM (Double Data Rate-SDRAM).

With respect to such a memory, patent document 1 discloses a memory controller that includes a plurality of programmable timing registers that can be programmed to store timing data fit to a memory device. Patent Document 2 discloses a memory card that incorporates therein a microprocessor chip and a nonvolatile memory chip that are connected to each other via an internal card bus, the microprocessor chip containing key data, usage data and program command data. Patent Document 3 discloses a computer system having an input/output processor provided as a built-in processor connected to a local memory. Patent Document 4 discloses a memory having an SPI driver and a memory means that are arranged inside the memory. Patent Document 5 discloses a data processing system including a CPU that is linked to a data memory via a single-direction readout bus, a single-direction writing-in bus and an address bus. Patent Document 6 discloses a memory system in which a memory controller is connected to a memory via a writing-in data transfer bus and a readout data transfer bus that are separately disposed. Patent Document 7 discloses a random-access memory configured in such a way that data transfer to random-access memories is controlled in response to first translation of a period signal and data transfer from an array of random-access memories is controlled in response to second translation of the period signal Patent Document 8 discloses a semiconductor memory device that includes a DRAM, and a CDRAM having a DRAM control and cache/refresh control unit. Patent Document 9 discloses a synchronous DRAM that has a memory array and a control unit and that allows setting of a mode register only when the data contents of a data bus is equal to operation status check data. Patent Document 10 discloses a mode register control circuit provided as an SDRAM and so on.

US 5,812,491 A shows a mode register control circuit for controlling read and write operations of a mode register of a semiconductor devices.

US 6,691,204 B1 shows a memory device having memory banks as well as a non-volatile mode register and a volatile mode register. when power is turned on, data are transferred from the non-volatile mode register to the volatile mode register*.*

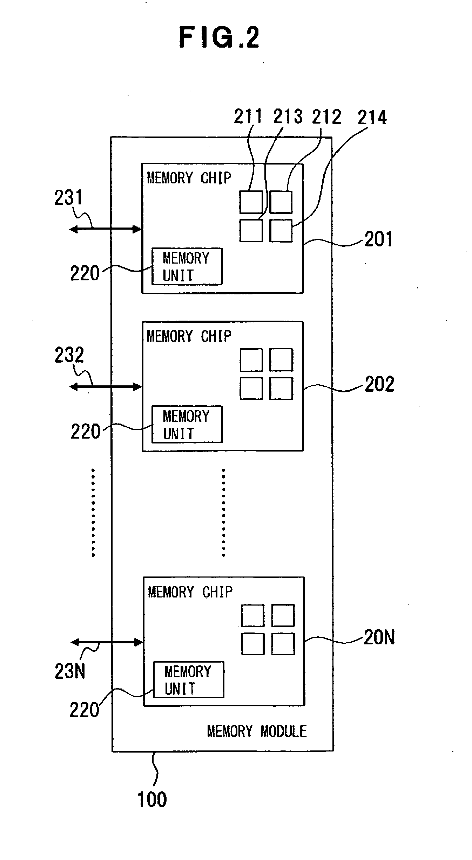

US 6,594,167 B1 shows a memory board carrying a plurality of memory chips each having a mode register and memory banks.
[Patent Document 1] Japanese Patent Application Laid-Open Publication No. 2004-110785 (ABSTRACT, Fig. 1, etc.)
[Patent Document 2] Japanese Patent Application Laid-Open Publication No. (H)06-208515 (ABSTRACT, Fig. 1, etc.)
[Patent Document 3] Japanese Patent Application Laid-Open Publication No. (H)09-6722
(ABSTRACT, Fig. 2, etc.)
[Patent Document 4] Japanese Patent Application Laid-Open Publication No. 2005-196486 (paragraph 0029, Fig. 6, etc.)
[Patent Document 5] Published Japanese Translations of PCT International Publication for Patent Application No. (H)09-507325 (ABSTRACT, Fig. 1, etc.)
[Patent Document 6] Japanese Patent Application Laid-Open Publication No. 2002-63791 (ABSTRACT, Fig. 1, etc.)
[Patent Document 7] Japanese Patent Application Laid-Open Publication No. (H)11-328975 (ABSTRACT, Fig. 2, etc.)
[Patent Document 8] Japanese Patent Application Laid-Open Publication No. (H)07-169271 (paragraph 0038, Fig. 1, etc.)
[Patent Document 9] Japanese Patent Application Laid-Open Publication No. (H)08-124380 (paragraph 0020, Fig. 2, etc.)
[Patent Document 10] Japanese Patent Application Laid-Open Publication No. (H)09-259582 (paragraph 0028, Fig. 1, etc.)

### [Disclosure of the Invention]

### [Problems to Be Solved by the Invention]

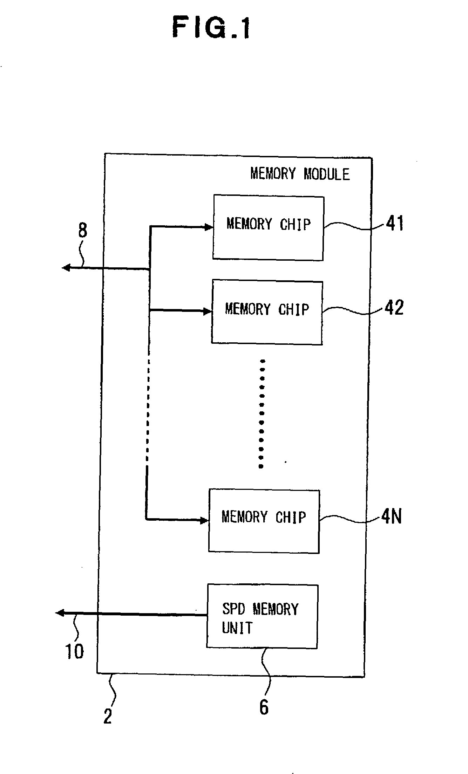

As shown in Fig. 1, a conventional memory module 2 includes a circuit board that carries a plurality of memory chips 41, 42, ... and 4N and an SPD (Serial Presence Detect) memory unit 6. The memory chips 41, 42, ... and 4N are connected to a memory access bus 8, and the SPD memory unit 6 is connected to an SPD access bus 10. In this memory module 2, the specifications and functions of the memory chips 41, 42, ... and 4N, such as types and timing parameters of the memory chips, are stored on the SPD memory unit 6. As a result, consistency of the memory module 2 with a setting environment depends on storage data stored on the SPD memory unit 6, which is comprised of such a nonvolatile memory as EEPROM (Electrically Erasable Programmable Read-Only Memory). Keeping control parameters necessary for memories in a component separated from the memories requires handling and control corresponding to the separate parameter storage, leading to an increase in various costs including product cost and writing-in cost.

Although the memory module 2 has a number of memory chips 41, 42, ... and 4N, the specification of each of the memory chips 41, 42, ... and 4N is regulated by the SPD memory unit 6. This makes impossible separate use of each of the memory chips 41, 42, ... and 4N as a memory chip having a different specification. In other words, such a memory module 2 lacks flexibility in practical use.

Patent Documents 1 to 10 suggest or disclose nothing about the above problems, and disclose nothing about a solution to the problems, either.

An object of the present invention is to improve the flexibility of a memory having a plurality of memory chips by enabling separate use of each of the memory chips as a memory chip having a different specification.

Another object of the present invention is to separately control each of memory chips to optimize a memory.

Still another object of the present invention is to improve compatibility of a memory.

### [Means for Solving the Problems]

In order to achieve the above objects, a memory device of the present invention is defined in claim 1 and has a plurality of memory chips each of which has a memory part that stores thereon control data on each memory chip, such as specification data and function data on the memory chip. The memory part enables rewriting of control data on the memory chip of the memory device, and, when the memory device has the plurality of memory chips, enables separate use of each of the memory chips based on the stored control data.

To achieve the above objects, a first aspect of the present invention provides a memory device of claim 1 including a plurality of memory chips, comprising each memory chip that has a memory part storing control data concerning the memory chip. In such a configuration, the memory chips are memory component units making up the memory device provided as a memory module and so on. Each memory chip includes a single or a plurality of memory matrixes. In this configuration, control data concerning the memory chip is stored on the memory part, and the control data stored on the memory part enables data reading/writing on a memory-chip-to-memory-chip basis and is rewritable as storage data stored on the memory part. Hence the above object is achieved.

To achieve the above objects, in the memory device, the memory chip has a plurality of memory matrixes. The control data are specification data and/or function data concerning the memory chip and the memory part includes a first memory element storing fixed data and a second memory element storing fluctuation data.

To achieve the above objects, in the memory device, preferably, the fluctuation data of the memory chip stored on the second memory element may be readable and writable based on address data specifying the memory chip.

To achieve the above objects, in the memory device, preferably, the first memory element may be comprised of a nonvolatile memory element.

To achieve the above objects, in the memory device, preferably, the second memory element may include a memory element capable of data reading/writing.

To achieve the above objects, a second aspect of the present invention provides a control method for a memory device having a plurality of memory chips, the method being defined in claim 6 and comprising a step of reading and writing control data concerning each memory chip based on address data specifying the memory chip. According to such a configuration, a memory chip is specified by using address data concerning the memory chip, and rewriting control data stored on the memory part of the identified memory chip allows the memory chip to deal with a change in a service environment and so on. This improves compatibility of the memory device and optimizes the memory device.

To achieve the above obj ects, a third aspect of the present invention provides a control program of claim 7 for a memory device having a plurality of memory chips, the program driving a computer to execute a process of reading and writing control data on each memory chip from/to the memory chip based on address data specifying the memory chip. According to such a configuration, the control program is executed by a computer apparatus at electronic equipment, such as a computer equipped with the memory device. In execution of the control program, a memory chip is specified by using address data concerning the memory chip. The computer apparatus rewrites control data stored on the memory part of the identified memory chip to allow the memory chip to deal, with a change in a service environment and so on. This improves compatibility of the memory device and optimizes the memory device, thus achieves the above objects.

To achieve the above objects, the present invention also provides a memory card provided with the memory device of the invention. single or a plurality of memory Such a configuration also achieves the above objects.

To achieve the above objects, in the memory card, the memory chip has a plurality of memory matrixes.

To achieve the above objects, in the memory card, the memory part includes a first memory element storing fixed data and a second memory element storing fluctuation data.

To achieve the above objects,in the memory card, preferably, fluctuation data of the memory chip stored on the second memory element may be readable from and writable on the second memory element based on address data specifying the memory chip.

To achieve the above objects, in the memory card, preferably, the first memory element may be comprised of a nonvolatile memory element.

To achieve the above objects, the present invention also provides circuit board provided with the memory device of the invention. Such a configuration also achieves the above objects.

To achieve the above objects, preferably, a slot into which the memory card is fitted may be comprised on a circuit board.

To achieve the above objects, the present invention also provides electronic equipment comprising the memory device. This electronic equipment may be provided as any form of equipment such as a computer, as long as it carries out data storage using the memory device. Such a configuration also achieves the above object.

To achieve the above objects, the present invention also provides electronic equipment comprising the circuit board. In this case, the electronic equipment may be also provided as any form of equipment such as a computer, as long as it carries out data storage using the memory device. Such a configuration also achieves the above object.

To achieve the above objects, the present invention also provides electronic equipment comprising the memory card. In this case, the electronic equipment may be also provided as any form of equipment such as a computer, as long as it carries out data storage using the memory device. Such a configuration also achieves the above object.

### [Effects of the Invention]

The present invention offers the following effects.
(1) Each memory chip has an internal memory part storing thereon control data on the memory chip. This enables the use of memory chips on a memory-chip-to-memory-chip basis using the control data stored on the memory part, and allows the memory chip to deal with an environment change such as specification change, in correspondence to the control data stored on the memory part, thus improves flexibility of the memory device.
(2) Each of memory chips is controlled separately to optimize a memory.
(3) Control data stored on the memory part in the memory chip is rewritten to improve compatibility of a memory.

Other objects, features, and advantages will become more apparent with reference to the accompanying drawings and embodiments.

### [Brief Description of the Drawings]

[Fig. 1] Fig. 1 is a view of a configuration of a conventional memory module;
[Fig. 2] Fig. 2 is a view of an exemplary configuration of a memory module of a first embodiment;
[Fig. 3] Fig. 3 is a block diagram of an exemplary configuration of a memory chip;
[Fig. 4] Fig. 4 shows timing charts of input/output control at a control register;
[Fig. 5] Fig. 5 is a view of an exemplary configuration of a personal computer of a second embodiment;
[Fig. 6] Fig. 6 is a flowchart of a procedure of a control data writing-in/rewriting process;
[Fig. 7] Fig. 7 is a view of an exemplary configuration of a memory card of a third embodiment; and
[Fig. 8] Fig. 8 is a view of an exemplary configuration of a circuit board of a fourth embodiment.

### [Explanation of Letters or Numerals]

100 memory module
201, 202, 203, ..., 20N memory chip
211, 212, 213, 214 memory matrix
220 memory unit
221 SPD memory unit
222 control register
231, 232, 233, ..., 23N bus
300 personal computer
318 memory module processing program
400 memory card
500 circuit board

### [Best Modes for Carrying Out the Invention]

### [First Embodiment]

A first embodiment of the present invention will be described with reference to Fig. 2, which depicts an exemplary configuration of a memory module of the first embodiment. Fig. 2 depicts an example of a memory device of the present invention. The configuration of the memory device of the present invention, therefore, is not limited to the configuration shown in Fig. 2.

The memory module 100 is an example of the memory device of the present invention. For example, the memory module 100 includes a circuit board that carries a plurality of memory chips 201, 202, ... and 20N. The memory chips 201, 202, ... and 20N are memory component units, and need not to be the minimum component units but may be configured to be different from the memory component units. In this embodiment, the memory module 100 is comprised of the plurality of memory chips 201, 202, ... and 20N. The memory module 100, however, may be constructed as a single memory module.

Each of the memory chips 201, 202, ... and 20N has, for example, four memory matrixes 211, 212, 213 and 214 serving as a plurality of banks, and a memory unit 220 storing fixed data and fluctuation data of control data. Each memory unit 220 as a memory part is comprised of a ROM (Read-Only Memory), RAM (Random-Access Memory), nonvolatile memory, etc. , and separately stores on the memory unit 220, for example, specification data and/or function data as control data on one of the memory chips 201, 202, ... and 20N that corresponds to the memory unit 220. Specifically, a memory unit 220 disposed on the memory chip 201 stores on the memory unit 220 specification data and/or function data on the memory chip 201, and a memory unit 220 disposed on the memory chip 202 stores on the memory unit 220 specification data and/or function data on the memory chip 202.

The memory chips 201, 202, ... and 20N are connected to buses 231, 232, ... and 23N, respectively. This enables data reading/writing from/to any one of the memory chips 201 to 20N that is identified by address data, and also enables writing in and rewriting of specification data and/or function data stored on the memory unit 220, based on address data specifying any one of the memory chips 201 to 20N.

In such a configuration, although the specifications and functions of the plurality of memory chips 201 to 20N mounted on the memory module 100 are regulated by specification data and/or function data stored on the memory units 220 of the memory chips, each of the memory chips 201 to 20N can be used as a memory chip having a different configuration by using storage data stored on each memory unit 220. In other words, the storage data stored on the memory unit 220 functions as identification data that identifies each of the memory chips 201 to 20N or the memory module 100 as a whole.

When the storage data stored on the memory unit 220 is allowed to function as identification data on the memory chips 201 to 20N, each of the memory chips 201 to 20N is identified by the storage data, which enables separate data reading/writing. Despite of being incorporated in the single memory module 100, therefore, each of the memory chips 201 to 20N can be separately used as a memory chip having a different standard, that is, a different specification and function. The memory module 100 thus constitutes the memory device that is highly flexible.

Since each of the memory chips 201 to 20N can be controlled separately based on the storage data stored on the memory unit 220, the specification or function of each of the memory chips 201 to 20N or of the memory module 100 may be changed to deal with a given service environment. This optimizes the memory and improves the compatibility of the memory.

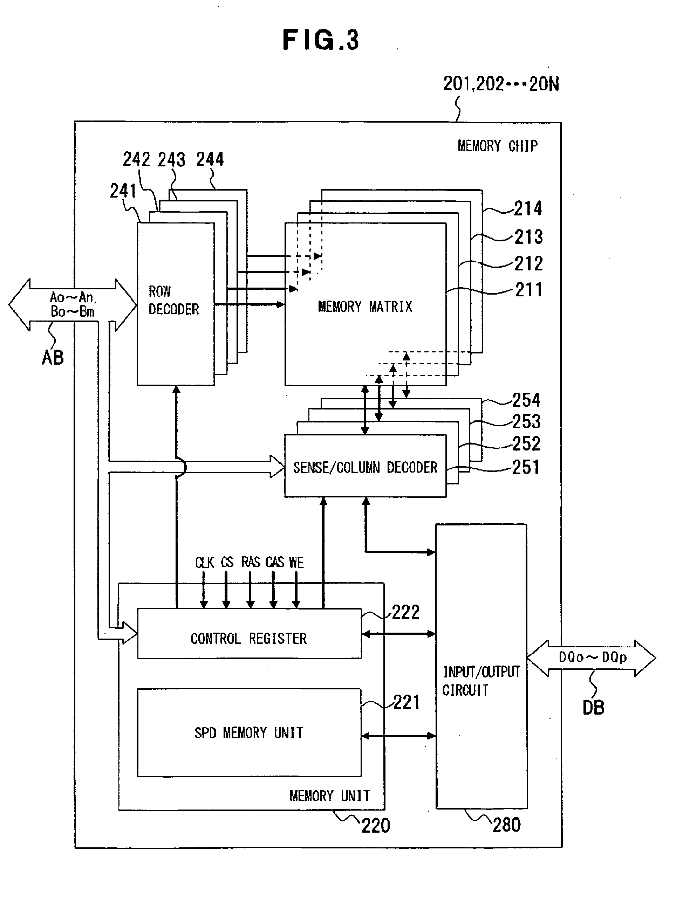

The memory chips 201 to 20N arranged on the memory module 100 will then be described with reference to Fig. 3. Fig. 3 is a block diagram of an exemplary configuration of a memory chip. In Fig. 3, the same components as described in Fig. 2 are denoted by the same reference numerals.

Each of the memory chips 201 to 20N includes a plurality of the memory matrixes 211 to 214, row decoders 241, 242, 243 and 244 that correspond to the memory matrixes 211, 212, 213 and 214, respectively, and sense/column decoders 251, 252, 253 and 254 that correspond to the memory matrixes 211, 212, 213 and 214, respectively. Each of the memory matrixes 211 to 214 has a plurality of memory cells arranged in a matrix form, i.e., rows and columns of memory cells. In this case, an N bit address signal passes through an N bit row buffer, and, in response to a row address selection signal RAS, comes into the row decoders 241 to 244, where a row of memory cells are selected. In response to a column address selection signal CAS, the N bit address signal then comes into sense/column decoders 251 to 254, where a column of memory cells are selected, which enables data reading and writing. Each of the memory matrixes 211 to 214 is capable of such an operation.

The memory unit 220 has an SPD memory unit 221 serving as a first memory element, and a control register 222 serving as a second memory element. The SPD memory unit 221 stores thereon CAS (Column Address Strobe) latency that is fixed data and also is specification data and/or function data, and so on. The control register 222 stores thereon fluctuation data such as data read out of the SPD memory unit 221 and external function data. Specification data and/or function data as control data stored on the control register 222 is read and written based on address data from an address bus AB. Ao to An denote writing-in addresses, and Bo to Bm denote bank addresses.

The SPD memory unit 221 and the control register 222 of the memory unit 220 are connected to an input/output circuit 280, which is connected to a data bus DB, through which specification data and/or function data, etc., is exchanged with an external device. DQo to DQp denote data.

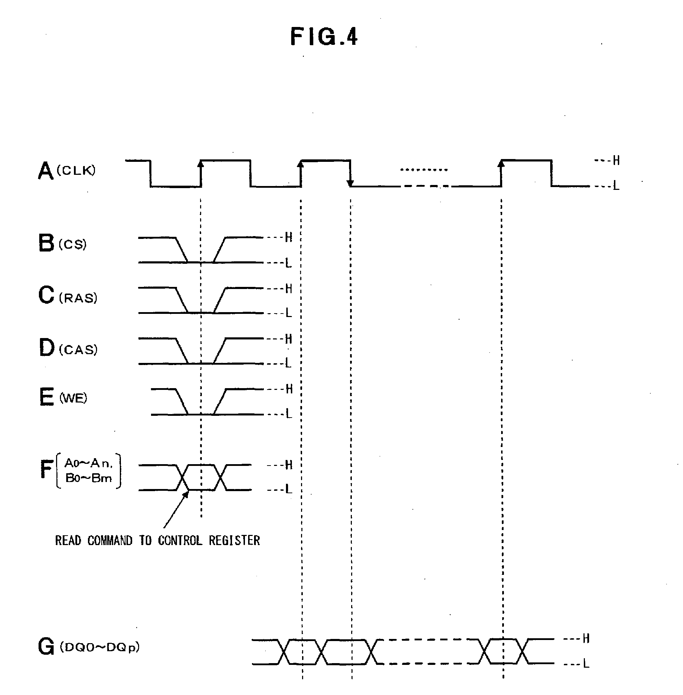

In such a configuration, the control register 222 receives input of a clock signal CLK (denoted by A in Fig. 4), a chip select signal CS (denoted by B in Fig. 4), the row address selection signal RAS (denoted by C in Fig. 4), the column address selection signal CAS (denoted by D in Fig. 4), a write enable signal WE (denoted by E in Fig. 4), and address data Ao to An and Bo to Bm (denoted by F in Fig. 4) as read commands, as shown in Figs. 4A to 4F. Receiving such read command signals, the control register 222 sends output data DQo to DQp (denoted by G in Fig. 4) through the input/output circuit 280 into the data bus DB 264.

To the control register 222, data read out of the SPD memory unit 221 is also transferred, so that the functions and operation of the memory matrixes 211 to 214 are determined based on specification data or function data stored on the control register 222.

### [Second Embodiment]

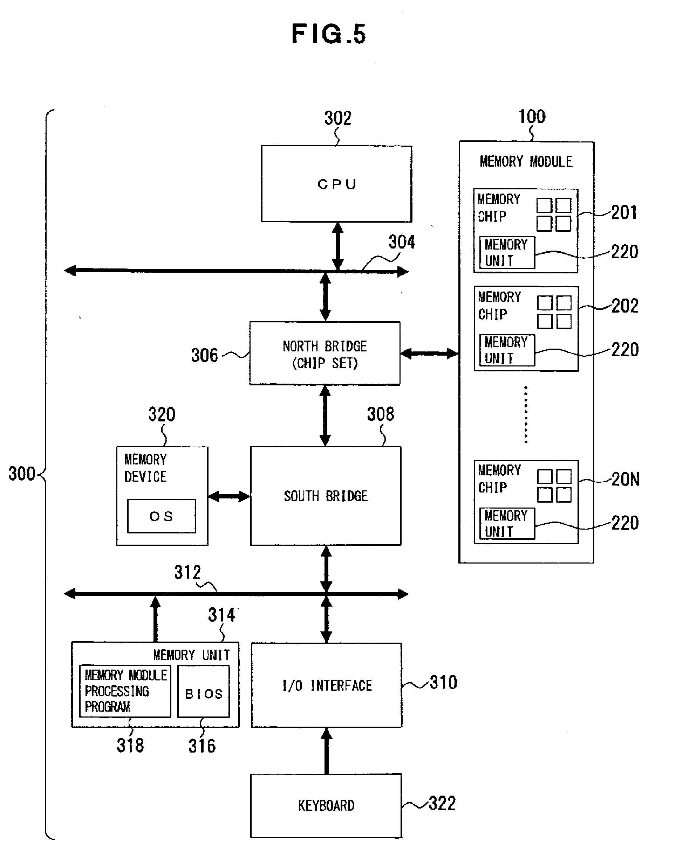

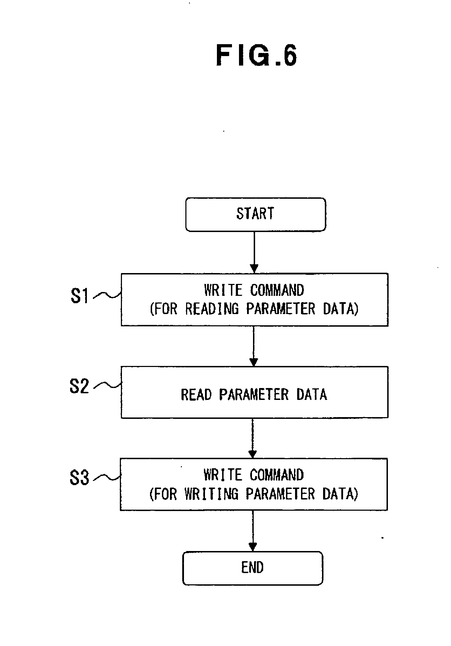

A second embodiment of the present invention will be described with reference to Figs. 5 and 6. Fig. 5 depicts an exemplary configuration of a personal computer (PC) of the second embodiment, and Fig. 6 is a flowchart of a procedure of a process of writing in or reading out storage data to and from a memory part. In Fig. 5, the same components as described in Fig. 2 or 3 are denoted by the same reference numerals.

The PC 300 is an example of electronic equipment having the memory module 100, and is capable of reading and writing storage data stored on each of the memory unit 220 of the memory chips 201 to 20N of the memory module 100, based on address data.

The PC 300 includes a CPU (Central Processing Unit) 302, which is connected to a north bridge (chip set) 306 via a bus 304. The north bridge 306 is connected to the memory module 100, and is also connected to an input/output (I/O) interface 310 via a south bridge 308. The north bridge 306 is a means that carries out data exchange between the CPU 302 and the memory module 100, and the south bridge 308 is a means that carries out data exchange between the CPU 302 and the I/O interface 310.

The memory module 100 has the above configuration (shown in Figs. 2 and 3), in which the same components as described above are denoted by the same reference numerals for saving further description.

To a bus 312 interposed between the south bridge 308 and the I/O interface 310, a memory unit 314 composed of a nonvolatile memory and so on is connected. The memory unit 314 stores thereon a BIOS (Basic Input/Output System) 316 and a memory module processing program 318 for writing in or rewriting control data stored on each memory unit 220 of the memory module 100. The memory module processing program 318 can be executed by an operation system (OS) that is stored on a memory device 320 composed of such a nonvolatile memory as a hard disc drive (HDD). The I/O interface 310 is connected to input/output devices such as a keyboard 322 and a display device not shown here.

Writing in or rewriting of control data in the memory module 100 in the above configuration will be described with reference to Fig. 6. Fig. 6 is a flowchart of a procedure of a process of writing in or rewriting control data.

Ordinary memory access is made to an address on a memory. In reading or writing parameters as control data, access is made to an address for parameter data writing/reading, etc., on a command register in the north bridge 306, which is a memory controller, and to an address on a data register for parameter reading and so on.

In a memory initialization procedure, writing of a command (for reading parameter data) is carried out first (step S1). Subsequently, reading of parameter data is carried out (step S2). Then, writing of a command (for writing parameter data) is carried out (step S3), and the procedure is ended. As a result, control data representing a specification and function is written to the memory unit 220 of the memory module 100, or control data stored on the memory unit 220 can be updated.

### [Third Embodiment]

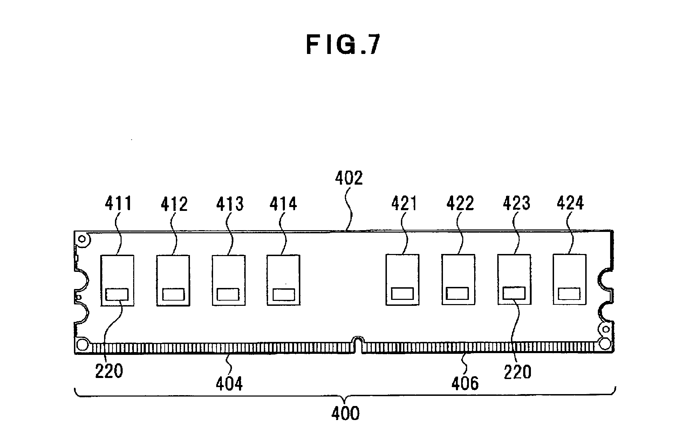

A third embodiment of the present invention will be described with reference to Fig. 7. Fig. 7 depicts an exemplary configuration of a memory card of the third embodiment. In Fig. 7, the same components as described in Fig. 2 or 3 are denoted by the same reference numerals.

The memory card 400 is a specific embodiment of the above described memory module 100. The memory card 400 includes a circuit board 402 having connectors 404 and 406 that are inserted into a socket on a motherboard side to provide electrical connection. The connector 404 carries four memory chips 411, 412, 413 and 414, and the connector 406 carries four memory chips 421, 422, 423 and 424. Each of the memory chips 411 to 414 and 421 to 424 has the above mentioned memory matrixes 211 to 214 and memory unit 220.

As described above, this memory card 400 can be used separately as a memory card having a different specification and function, thus serving as a memory device having extremely high flexibility. The memory card 400 allows a change in specification and function and is able to deal with a given service environment, thus enables optimization and improvement in compatibility of the memory.

### [Fourth Embodiment]

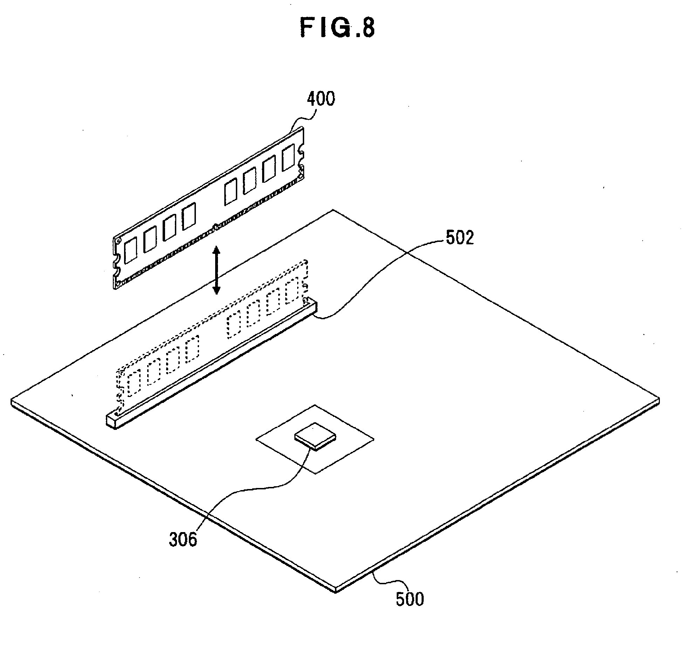

A fourth embodiment of the present invention will be described with reference to Fig. 8. Fig. 8 depicts an exemplary configuration of a circuit board of the fourth embodiment. In Fig. 8, the same components as described in Fig. 2, 3, 5, or 7 will be denoted by the same reference numerals.

The circuit board 500 includes a memory slot 502 in which the memory card 400 equipped with the above described memory module 100 is fitted, and a north bridge 306. The north bride 306 and the memory slot 602 are connected to each other via a bus to be able to exchange data with each other.

According to the circuit board 500, control data is written in on each of the memory units 220 incorporated in the memory card 400 to achieve highly flexible memory access.

### [Other Embodiments]

Modifications, features, etc. of the above embodiments will be enumerated as follows.
(1) As described in the above embodiments, the memory module 100 assumes a function of a memory interface, thus maintaining high compatibility. Maintaining compatibility means, for example, that a module equipped with a memory chip can be used permanently because of its compatibility.
(2) The memory unit 220 of each of the memory chips 201 to 20N may be given a program-based determining function. In such a case, if timing of interfacing is different depending on product generation of the memory chips, a separate control interface may be provided for identifying a memory chip.
(3) In the above embodiments, the PC 300 is described as electronic equipment that is an application example of the memory device. The present invention, however, may apply widely to a TV set with a PC function, server, telephone set, etc.

While the preferred embodiments of the present invention have been described, the description is not intended to limit the present invention. Various modifications and variants will be apparent to those skilled in the art based on the substance of the invention described in the appended claims or disclosed in the specification, and such modifications and variants obviously fall within the true scope of the invention.

### [Industrial Applicability]

According to the present invention, each of memory chips has an internal memory part storing thereon control data on the memory chip, such as specification data and/or function data on the memory chip. This is useful to enable the use of the memory device on a memory-chip-to-memory-chip basis, allow the memory chips to deal with an environment change such as a specification change, thus optimize the memory and improve flexibility and compatibility of the memory.

## Claims

1. A memory card (400) including a plurality of memory chips (201, 202, ..., 20N),
wherein
- each memory chip comprises
-- a memory part (220), storing control data concerning the memory chip for regulating a specification or a function of the memory chip;
-- a plurality of banks, and
-- an input/output part (280) connected to the memory part (220) and to a data bus (DB) for connection to an external device,
- wherein the memory part (220) includes a first memory element (221) storing fixed data,
- wherein the control data include at least the fixed data provided from the first memory element (221),
- wherein the first memory element and a second memory element (221, 222) are connected to the input/output part (280) for writing the fixed data from the first memory element (221) into the second memory element (222) and wherein
- the second memory element (222) is included in the memory part (220) of each chip and is storing fluctuation data provided from the input/output part (280), and
- the control data stored in the memory part (220) is different in each of the memory chips, a function or an operation of each of the plurality of banks is controlled based on the control data stored in the memory parts (220), respectively, and the specification or the function of each of the memory chip is differently regulated.

2. The memory card (400) of claim 1, wherein the plurality of banks compose a plurality of memory matrixes (211, 212, 213, 214).

3. The memory card (400) of claim 1, wherein the fluctuation data of the memory chip stored on the second memory element (222) is readable and writable based on address data specifying the memory chip.

4. The memory card (400) of claim 1, wherein the first memory element (221) is comprised of a nonvolatile memory element.

5. The memory card (400) of claim 1, wherein the second memory element (222) includes a memory element capable of data reading / writing.

6. A control method for a memory card (400) according to any of claims 1 to 5, **characterized in** comprising a step of
- reading and writing the control data based on address data specifying the memory chip and controlling a function or an operation of each of the plurality of banks of the memory chip based on the control data,
- wherein fixed data is written from the first memory element (221) into the second memory element (222) and a specification or a function of the memory chip is regulated by the control data including the fixed data stored in the second memory element (222), and
- wherein the specification or the function of each of the memory chips is differently regulated by storing the control data, which is different in each of the memory chips.

7. A control program (318) for the memory card of any one of claims 1 to 5,
**characterized in**
driving a computer to execute the method of claim 6.

8. A circuit board (500) provided with a memory card (400) according to claim 1.

9. A circuit board (500) comprising a slot into which the memory card (400) of claim 1 is fitted.

10. Electronic equipment (300) comprising the memory card of any one of claims 1 to 5.

11. Electronic equipment (300) comprising the circuit board (500) of claim 8 or 9.

## Patentansprüche

1. Speicherkarte (400), die mehrere Speicherchips (201, 202, ..., 20N) enthält, wobei
- jeder Speicherchip umfaßt:
-- einen Speicherbereich (220), der den Speicherchip betreffende Steuerdaten zur Festlegung einer Spezifikation oder einer Funktion des Speicherchips speichert:
-- mehrere Speichermodule und
-- einen Input/Output-Bereich (280), der mit dem Speicherbereich (220) sowie mit einem Datenbus (DB) zur Verbindung mit einem externen Gerät verbunden ist,
- wobei der Speicherbereich (220) ein erstes Speicherelement (221) enthält, welches Festdaten speichert,
- wobei die Steuerdaten mindestens die vom ersten Speicherelement (221) bereitgestellten Festdaten enthalten,
- wobei das erste Speicherelement und ein zweites Speicherelement (221, 222) mit dem Input/Output-Bereich (280) verbunden sind, um die Festdaten vom ersten Speicherelement (221) auf das zweite Speicherelement (222) zu schreiben,
und wobei
- das zweite Speicherelement (222) im Speicherbereich (220) eines jeden Chips enthalten ist und vom Input/Output-Bereich (280) bereitgestellte Fluktuationsdaten speichert und
- die im Speicherbereich (220) gespeicherten Steuerdaten auf jedem der Speicherchips unterschiedlich sind, eine Funktion oder ein Vorgang von jedem der mehreren Speichermodule auf Grundlage der jeweils in den Speicherbereichen (220) gespeicherten Steuerdaten gesteuert wird, und die Spezifikation oder Funktion eines jeden Speicherchips unterschiedlich festgelegt ist.

2. Speicherkarte (400) nach Anspruch 1, wobei die mehreren Speichermodule mehrere Speichermatrizen (211, 212, 213, 214) bilden.

3. Speicherkarte (400) nach Anspruch 1, wobei die auf dem zweiten Speicherelement (222) gespeicherten Fluktuationsdaten des Speicherchips auf der Grundlage von Adreßdaten, die den Speicherchip bezeichnen, les- und schreibbar sind.

4. Speicherkarte (400) nach Anspruch 1, wobei das erste Speicherelement (221) aus einem nichtflüchtigen Speicherelement besteht.

5. Speicherkarte (400) nach Anspruch 1, wobei das zweite Speicherelement (222) ein Speicherelement umfaßt, welches Daten lesen und schreiben kann.

6. Steuerungsverfahren für eine Speicherkarte (400) nach einem der Ansprüche 1 bis 5,
**dadurch gekennzeichnet, daß** es einen Schritt des
- Lesens und Schreibens der Steuerdaten auf Grundlage der Adreßdaten, die den Speicherchip bezeichnen, und des Steuerns einer Funktion oder eines Vorgangs eines jeden der mehreren Speichermodule des Speicherchips auf Grundlage der Steuerdaten umfaßt,
- wobei Festdaten vom ersten Speicherelement (221) auf das zweite Speicherelement (222) geschrieben werden und eine Spezifikation oder Funktion des Speicherchips von den Steuerdaten, einschließlich der im zweiten Speicherelement (222) gespeicherten Festdaten, festgelegt wird und
- wobei die Spezifikation oder die Funktion eines jeden Speicherchips durch die Speicherung der Steuerdaten, die auf jedem der Speicherchips verschieden sind, unterschiedlich festgelegt wird.

7. Steuerprogramm (318) für die Speicherkarte nach einem der Ansprüche 1 bis 5,
**dadurch gekennzeichnet, daß**
es einen Computer steuert, das Verfahren nach Anspruch 6 auszuführen.

8. Elektronikkarte (500), die mit einer Speicherkarte (400) nach Anspruch 1 ausgestattet ist.

9. Elektronikkarte (500), die einen Slot enthält, in den die Speicherkarte (400) nach Anspruch 1 eingepaßt ist.

10. Elektronische Ausrüstung (300), umfassend die Speicherkarte nach einem der Ansprüche 1 bis 5.

11. Elektronische Ausrüstung (300), umfassend die Elektronikkarte (500) nach Anspruch 8 oder 9.

## Revendications

1. Carte de mémoire (400) incluant une pluralité de circuits intégrés de mémoire (201,202, ..., 20N),
- dans laquelle chaque circuit intégré de mémoire comprend:
-- une section de mémoire (220), mémorisant des données de commande concernant le circuit intégré de mémoire pour réguler une spécification ou une fonction du circuit intégré de mémoire;
-- une pluralité de blocs; et
-- une section d'entrée/sortie (280) connectée à la section de mémoire (220) et à un bus de données (DB) pour connexion à un dispositif externe,
- dans laquelle la section de mémoire (220) inclut un premier élément de mémoire (221) mémorisant des données fixes,
- dans laquelle les données de commande incluent au moins les données fixes fournies à partir du premier élément de mémoire (221),
- dans laquelle le premier élément de mémoire et un second élément de mémoire (221, 222) sont connectés à la section d'entrée/sortie (280) pour écrire dans le second élément de mémoire (222) les données fixes provenant du premier élément de mémoire (221),
et dans laquelle:
- le second élément de mémoire (222) est inclus dans la section de mémoire (220) de chaque circuit intégré et mémorise des données de fluctuation fournies à partir de la section d'entrée/sortie (280), et
- les données de commande mémorisées dans la section de mémoire (220) sont différentes dans chacun des circuits intégrés de mémoire, une fonction ou une opération de chacun de la pluralité de blocs est commandée à partir des données de commande mémorisées dans les sections de mémoire (220), respectivement, et la spécification ou la fonction de chacun des circuits intégrés de mémoire est régulée différemment.

2. Carte de mémoire (400) selon la revendication 1, dans laquelle la pluralité de blocs compose une pluralité de matrices de mémoire (211, 212, 213, 214).

3. Carte de mémoire (400) selon la revendication 1, dans laquelle les données de fluctuation du circuit intégré de mémoire mémorisées sur le second élément de mémoire (222) peuvent être lues et écrites à partir de données d'adresse spécifiant le circuit intégré de mémoire.

4. Carte de mémoire (400) selon la revendication 1, dans laquelle le premier élément de mémoire (221) est composé d'un élément de mémoire non volatile.

5. Carte de mémoire (400) selon la revendication 1, dans laquelle le second élément de mémoire (222) inclut un élément de mémoire capable de lire/écrire des données.

6. Procédé de commande pour une carte de mémoire (400) selon l'une quelconque des revendications 1 à 5,
**caractérisé en ce qu'**il comprend une étape:
- de lecture et d'écriture des données de commande à partir de données d'adresse spécifiant le circuit intégré de mémoire et de commande, à partir des données de commande, d'une fonction ou d'une opération de chacun de la pluralité de blocs du circuit intégré de mémoire,
- dans lequel des données fixes sont écrites à partir du premier élément de mémoire (221) dans le second élément de mémoire (222) et une spécification ou une fonction du circuit intégré de mémoire est régulée par les données de commande incluant les données fixes mémorisées dans le second élément de mémoire (222), et
- dans lequel la spécification ou la fonction de chacun des circuits intégrés de mémoire est régulée différemment en mémorisant les données de commande, qui sont différentes dans chacun des circuits intégrés de mémoire.

7. Programme de commande (318) pour la carte de mémoire selon l'une quelconque des revendications 1 à 5, **caractérisé par** le pilotage d'un processeur pour mettre en oeuvre le procédé selon la revendication 6.

8. Carte de circuit (500) pourvue d'une carte de mémoire (400) selon la revendication 1.

9. Carte de circuit (500) comprenant un emplacement dans lequel se monte la carte de mémoire (400) selon la revendication 1.

10. Équipement électronique (300) comprenant la carte de mémoire selon l'une quelconque des revendications 1 à 5.

11. Équipement électronique (300) comprenant la carte de circuit (500) selon la revendication 8 ou 9.
